# EUROPÄISCHE PATENTSCHRIFT

(11) **EP 1 758 160 B1**
(45) Veröffentlichungstag und Bekanntmachung des Hinweises auf die Patenterteilung: **06.05.2015**
(21) Anmeldenummer: 06016295.5
(22) Anmeldetag: 04.08.2006
(51) Int. Cl.: H01L 21/677, H01L 21/00, B65G 49/06

(54) **Bearbeitungsanlage modularen Aufbaus für flächige Substrate**
Installation of modular construction for the working of flat substrates
Installation de construction modulaire pour le traitement de substrats plats

(30) Priorität: 26.08.2005 DE 102005040741
(43) Veröffentlichungstag der Anmeldung: 28.02.2007
(73) Patentinhaber: ASYS AUTOMATIC SYSTEMS GMBH & CO. KG, 73614 Schorndorf (DE)
(72) Erfinder: Hügler, Klaus, 73630 Remshalden (DE)
(74) Vertreter: Wittner, Walter

(56) Entgegenhaltungen:
- EP-A2- 0 574 893
- WO-A-97/38440
- WO-A-99/18603
- WO-A-2004/102055
- US-A- 2 676 780
- US-A1- 2003 053 894
- US-B1- 6 393 716

## Beschreibung

Die Erfindung betrifft eine Bearbeitungsanlage modularen Aufbaus für flächige Substrate gemäß dem Anspruch 1 und dem Anspruch 6.

Bekannt sind aus der US 2001/0024611 A1 Bearbeitungsanlagen von flächigen Substraten in Form von Wafern, insbesondere 300 mm-Wafern, bei denen in einer Einhausung beiderseits längsseitig der Führungsbahn einer Transfervorrichtung Prozessmodule angeordnet sind. Die Transfervorrichtung umfasst ein auf der Führungsbahn abgestütztes und längs derselben verfahrbares Handhabungsgerät mit in Richtung auf die Prozessmodule, also quer zur Führungsbahn ausfahrbaren Substratauflagen. Über diese erfolgt die Beschickung der Prozessmodule mit Wafern. Die Zufuhr der Wafer zur Transportvorrichtung erfolgt mittels Transportboxen, die die Wafer, in Kassetten gestapelt, aufnehmen und die an einem stirnseitigen Ende der Führungsbahn an die die Bearbeitungsanlage umschließende Einhausung angedockt im Zugriffsbereich des Handhabungsgerätes liegen.

Die Anordnung der Prozessmodule mit dazwischen liegender Transfervorrichtung, umfassend die Führungsbahn und die längs derselben verfahrbaren Transfermodule mit Substratauflagen, gewährleistet bei der über die Einhausung angestrebten Isolierung des umschlossenen Raumes gegenüber der jeweiligen atmosphärischen Umgebung zwar einen gewissen Schutz der über die Transfervorrichtung auf die und zwischen den Prozessmodulen umzusetzenden Wafer gegen Verunreinigungen. Die Möglichkeiten, höhere Unterdrücke innerhalb der Einhausung zur Verbesserung der Isolation gegen Fremdgase und des Verschmutzungsschutzes aufzubringen, sind aber aus wirtschaftlichen und konstruktiven Gegebenheiten eingeschränkt, da höhere Unterdrücke und dadurch gegebene Druckdifferenzen zur Umgebungsatmosphäre eine entsprechend stabile und ausgasungsarme Gestaltung der Einhausung bedingen. Somit sind auch die Möglichkeiten beschränkt, über die Transportboxen Substrate in entsprechender Reinraumatmosphäre der Bearbeitungsanlage zuzuführen und diese Reinraumatmosphäre im von der Einhausung umschlossenen Raum, und somit während des Transportes über die Transfervorrichtung, aufrecht zu erhalten.

Gerade bei großflächigen mikroelektronischen Werkstücken, wie Flachbildschirmen, ist aber für einen schnellen Arbeitsdurchlauf bei vertretbarem Energieeinsatz über den Bearbeitungsprozess durchlaufend die Aufrechterhaltung einer gewünschten Rein- oder Reinstraumatmosphäre von Bedeutung, da für die bis zu mehreren Quadratmetern großen Substrate und die dafür erforderlichen Räume der Aufbau solcher Atmosphären zeit- und kostenintensiv ist. Einhausungen von dafür erforderlichem Ausmaß lassen sich aber auch unter wirtschaftlichen Gesichtspunkten nicht sinnvoll realisieren.

Dem wird bei einer aus der WO 97/38440 bekannten Lösung dadurch Rechnung getragen, dass auf die Einhausung der Bearbeitungsanlage in ihrer Gesamtheit verzichtet und somit ein Großreinraum vermieden wird. Stattdessen wird seitens der Prozess- wie auch des oder der Transfermodule mit in sich gekapselten Einheiten gearbeitet, die in den notwendigen Größen noch wirtschaftlich herstellbar sind, wobei aber sowohl die Prozessmodule wie auch die zu deren Belieferung eingesetzten Transfermodule in der Atmosphäre liegen und somit die Schwierigkeit besteht, Übergabevorgänge zwischen Transfer- und Prozessmodulen trotz der atmosphärischen Umgebung ohne Beeinträchtigung der in den Modulen gegebenen atmosphärischen Bedingungen zu gestalten.

Im Einzelnen ist hierzu vorgesehen, die gekapselten Prozessmodule und das wenigstens eine verfahrbare, an die Prozessmodule anzudockende, gekapselte Transfermodul jeweils mit Übergabeöffnungen zu versehen. Die seitens des Transfermoduls vorgesehene Übergabeöffnung ist durch eine Ventilplatte zu verschließen. Anzudocken ist das Transfermodul an ein jeweiliges Prozessmodul über eine vom Prozessmodul getragene Kupplungsvorrichtung, die zum Prozessmodul verstellbar an dieses über eine Faltenbalganordnung abgedichtet angeschlossen ist und die gegen das Transfermodul zu verriegeln ist. Die Kupplungsvorrichtung weist zu den übergabeöffnungen korrespondierende Durchgangsöffnungen auf, denen als Absperrglieder Sperrklappen zugeordnet sind, welche in ihrer Schließstellung über eine Abstützvorrichtung gegeneinander abgestützt sind und über die Abstützvorrichtung, die als Hebelanordnung gestaltet ist, in eine außerhalb des Übergabeweges zwischen den Übergabeöffnungen liegende Öffnungsstellung verschwenkbar sind. Über die zum Transfermodul benachbarte Sperrklappe wird dabei die der Übergabeöffnung des Transfermoduls zugeordnete Ventilplatte mitgenommen, so dass der Durchgangsweg zwischen Transfermodul und Prozessmodul freigegeben ist. Die Ausgestaltung der Abstützvorrichtung bedingt Reibkontakte zwischen deren Teilen, die zu Verunreinigungen der vorgegebenen Arbeitsatmosphäre führen können.

Des Weiteren ist aus der EP 0 574 893 A2 eine Bearbeitungsanlage modularen Aufbaus für flächige Substrate unter atmosphärischen Sonderbedingungen bekannt, bei der ein Transfermodul an ein jeweiliges Prozessmodul anzudocken ist und bei der den seitens der Module vorgesehenen Übergabeöffnungen Ventilplatten zugeordnet sind, die über magnetische Halterungen sowohl in ihrer Schließstellung zu fixieren sowie auch zur gemeinsamen Überführung in ihre Öffnungsstellung magnetisch miteinander zu verbinden sind.

Aus der US 2, 676, 780 A ist ferner ein Schieberventil bekannt, das einen quer zur Durchflussrichtung verstellbaren Sperrschieber aufweist. Dieser ist aus in Durchflussrichtung einander gegenüberliegenden Schieberplatten aufgebaut, die in Schließstellung des Schieberventils gegen in Durchflussrichtung einander gegenüberliegende, den Durchflussquerschnitt umgrenzende gehäuseseitige Dichtflächen anliegen und gegeneinander in Richtung auf diese Dichtflächen durch einen quer zur Durchflussrichtung eingefahrenen Keilschieber abgedrängt sind. Zwischen den zueinander korrespondierenden, in Einschubrichtung des Keilschiebers aufeinander zulaufenden Schieberflächen und den entsprechend geneigten, den Schieberplatten zugehörigen Gegenflächen liegen jeweils wälzabstützungen, die Zylinderrollen aufweisen, welche in seitens des Keilschiebers angeordneten und mit dem Keilschieber verfahrbaren Lagerkäfigen geführt sind.

Der Erfindung liegt die Aufgabe zugrunde, ungeachtet großer Durchsatzgeschwindigkeiten der Bearbeitungslage bei vergleichsweise einfachem Aufbau abriebbedingte Verunreinigungen der jeweiligen Arbeitsatmosphäre zu vermeiden.

Bezogen auf einen Aufbau der Bearbeitungsanlage gemäß Anspruch 1 wird dies für die der Kupplungsvorrichtung zugehörigen Sperrklappen durch eine Ausbildung der Abstützvorrichtung als zwischen'die Sperrklappen einfahrbarer Keilschieber erreicht, dessen Keilflächen zu entsprechend geneigten Gegenflächen der Sperrklappen korrespondieren, die über den Keilschieber dadurch berührungsfrei beaufschlagt sind, dass die Keilflächen des Keilschiebers und die Gegenflächen der Sperrklappen mit gleichpolig aufeinander ausgerichteten Magneten versehen sind. Die Abstützung wird somit berührungsfrei unter Nutzung magnetischer Abdrängkräfte erreicht, so dass atmosphärische Verunreinigungen vermieden sind.

Die Verwendung von Permanentmagneten ermöglicht dabei einen einfachen Aufbau, wobei in Verbindung mit parallel zu den jeweiligen Neigungsebenen der Keilflächen und der Gegenflächen liegenden Polflächen auch sehr enge Spalte und entsprechend hohe Abdrängkräfte zu realisieren sind.

Insbesondere durch eine teppichartige Anordnung der Magneten zu den jeweiligen Keilflächen und Gegenflächen lässt sich auch eine sehr gleichmäßige Verteilung der Abdrängkräfte erreichen, wobei ein über die Länge der Sperrklappen trogförmige Ausbildung des Keilschiebers zu günstigen Arbeitsverhältnissen führt.

Im Hinblick auf die schnelle Durchführung von Andockvorgängen ungeachtet der großen Volumina und Gewichte der Transfermodule und damit bei vertretbarem Aufwand auch kaum zu vermeidenden Lageungenauigkeiten erweist es sich als zweckmäßig, dass das Transfermodul umschließend zu seiner Übergabeöffnung mit einer Brille zu versehen, die federnd in Richtung auf die Kupplungsvorrichtung abgestützt ist und dichtend über eine Faltenbalgverbindung an dem Transfermodul bei schwimmender Abstützung festgelegt ist. Im Rahmen der durch die federnde Abstützung vorgegebenen Vorverlagerung der Brille gegenüber dem Transfermodul in Richtung auf die Kupplungsvorrichtung wird die Vorwärtsbewegung des Transfermodules abgebremst und es werden bei Lageungenauigkeiten zwischen feststehendem Prozessmodul und Transfermodul Schäden dadurch vermieden, dass die Brille bei Annäherung an die Kupplungsvorrichtung durch einander entsprechend seitens der Kupplungsvorrichtung und seitens der Brille angeordnete, gleichpolig einander gegenüberliegende Magnete berührungsfrei ebenenparallel zur Anschlussebene der Kopplungsvorrichtung ausgerichtet wird. Durch Abrieb bedingte Verunreinigungen der Übergangsspalte, und damit nach Öffnen des Übergangs auf die Kupplungsvorrichtung lassen sich so vermeiden.

In diesem Zusammenhang erweist es sich besonders als vorteilhaft, wenn die Spalte während des Zusammenfahrens durch Ausblasen auf die Atmosphäre gereinigt werden, und wenn im Gegenzug nach Anlegen der Brille an die Kupplungsvorrichtung die verbliebenen Spalte abgesaugt werden. Erreichbar ist dies durch eine entsprechende Luftversorgung über die Sperrklappe, wobei über die Dimensionierung der Sperrklappe ebenso wie der der Übergabeöffnung des Transfermoduls zugeordneten Ventilplatte entsprechende kleine Spaltquerschnitte freigehalten werden. Dies trägt wiederum dazu bei, dass Berührungen zwischen gegeneinander bewegten Teilen weitmöglichst vermieden werden.

Aufgrund der atmosphärischen Umgebungsbedingungen, die zu den Prozessmodulen und zu dem oder den Transfermodulen gegeben sind, in denen Reinraumbedingungen herrschen und aufrecht erhalten werden sollen, kann die Übergabeöffnung des zu verbindenden Modules über eine Ventilplatte verschlossen werden, die in ihrer Schließlage lediglich haftend, beispielsweise magnetisch, gehalten ist, da eine Druckbelastung in Richtung auf die Schließlage gegeben ist.

Weitere Einzelheiten und Merkmale der Erfindung ergeben sich aus den Ansprüchen. Ferner wird die Erfindung nachfolgend anhand eines Ausführungsbeispieles erläutert. Es zeigen:
- Fig. 1: eine perspektivische Darstellung einer modular aufgebauten Bearbeitungsanlage für großflächige Substrate mit Übergabemodulen und Bearbeitungsmodulen als Prozessmodulen und einer Transfervorrichtung, die längs einer Führungsbahn verfahrbare Transfereinheiten mit Transfermodulen umfasst,
- Fig. 2: eine vergrößerte und stark schematisierte Schnittdarstellung des Übergangsbereiches zwischen einem verfahrbaren Transfermodul und einem lagefesten Prozessmodul mit den Bereich zwischen den jeweiligen Übergabeöffnungen überbrückendem Übergabekanal,
- Fig. 3: eine weitere erfindungsgemäße Ausgestaltung einer Kupplungsvorrichtung, über die ein mobiles Modul mit einem lagefesten Modul zu verbinden ist und über die unter Aufrechterhaltung gegebener atmosphärischer Sonderbedingungen die Übergabe auch in atmosphärischer Umgebung ohne die Gefahr von Verunreinigungen bei hohen Durchlaufgeschwindigkeiten zu realisieren ist, in einer Schnittdarstellung gemäß III-III in Fig. 5,
- Fig. 4: eine vergrößerte Darstellung des Ausschnittes IV gemäß Fig. 3 in Richtung auf die Anschlussseite für ein Transfermodul und die dieser Anschlussseite zugeordnete Durchgangsöffnung,
- Fig. 5: eine Ansicht auf das Kupplungsgehäuse in Richtung auf eine Durchtrittsöffnung,
- Fig. 6: eine Ansicht in Richtung des Pfeiles VI in Fig. 5,
- Fig. 7: eine isolierte, schematische Darstellung einer Sperrklappe, die der Durchgangsöffnung der Kupplungsvorrichtung in Richtung auf das lagefeste Modul zugeordnet ist,
- Fig. 8: eine vergrößerte Darstellung der Einzelheit VIII in Fig. 6, und
- Fig. 9: eine vereinfachte Schnittdarstellung entsprechend der Schnittführung IX-IX in Fig. 5.

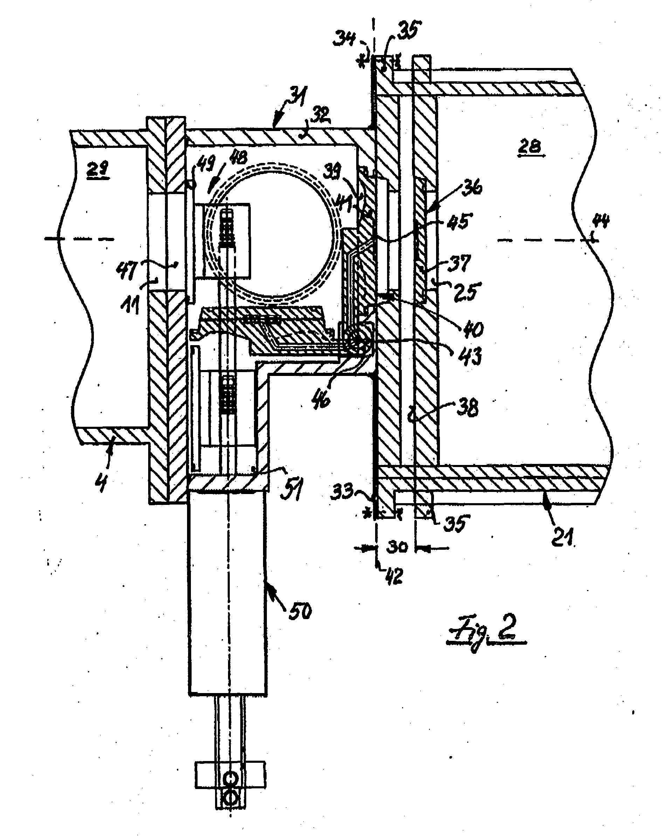

Eine Bearbeitungsanlage 1 umfasst eine größere Anzahl von gekapselten Prozessmodulen 2 bis 7, im Ausführungsbeispiel in Form eines Übergabemoduls 2 und von Bearbeitungsmodulen 3 bis 7, sowie von gekapselten Transfermodulen 21, 22 als Bestandteilen einer Transfervorrichtung 27. Die Prozessmodule 2 bis 7 sind mit gegen die Transfervorrichtung 27 gerichteten Übergabeöffnungen 8 bis 14 versehen, und korrespondierend weisen auch die Transfermodule 21, 22 jeweils eine Übergabeöffnung auf. Diese ist in dem in Fig. 2 ausschnittsweise veranschaulichten Transfermodul 21 mit 25 bezeichnet.

Die Transfervorrichtung 27 umfasst zwei längs der Reihe der Prozessmodule 2 bis 7 sich erstreckende und parallel zueinander verlaufende Führungsbahnen 15, 16, auf denen Transfereinheiten 17, 18 verfahrbar sind, die jeweils ein Transfermodul 21, 22 aufweisen und die unabhängig voneinander, so wie auch aneinander vorbei, längs der jeweiligen Führungsbahn 15, 16 verfahrbar sind, so dass jede der Transfereinheiten 17, 18 grundsätzlich jedes der Prozessmodule 2 bis 7 bedienen kann.

Die Transfermodule 21, 22 der Transfereinheiten 17, 18 weisen jeweils einen bevorzugt höhenverstellbaren und längs ihrer Führungsbahn 15, 16 verfahrbaren Führungsschlitten 19, 20 auf. Die Transfermodule 21, 22 sind mit ihren Übergabeöffnungen - wie in Fig. 2 für das Transfermodul 21 mit der Übergabeöffnung 25 gezeigt - an die Übergabeöffnungen 8 bis 14 der Prozessmodule 2 bis 7 anzudocken, wobei, wie in Fig. 2 des näheren dargestellt, dieser Andockvorgang zu einer dichten Verbindung zwischen dem jeweiligen Transfermodul 21, 22 und dem angedockten Prozessmodul 2 bis 7 führt, so dass die Innenräume 28, 29 von jeweils aneinander angedockten Prozessmodulen 2 bis 7 und Transfermodulen 21, 22 - in Fig. 2 der Innenraum 28 des Transfermodules 21 und der Innenraum 29 eines der Prozessmodule 2 bis 7, hier des als Bearbeitungsmodul ausgebildeten Prozessmodules 4 - über ihre Übergabeöffnungen, in Fig. 2 die Übergabeöffnungen 25 und 11, gegen die atmosphärische Umgebung 26 hermetisch abgeschlossen miteinander in Verbindung stehen.

Der dichtende Anschluss zwischen Prozessmodulen 2 bis 7 und Transfermodulen 21, 22 kann dadurch erfolgen, dass die Transfermodule 21, 22 quer zur jeweiligen Führungsbahn 15, 16 um das Freigangmaß 30 in Richtung auf die Prozessmodule 2 bis 7 verlagerbar, insbesondere angetrieben verlagerbar, sind, das in Berücksichtigung erforderlicher Toleranzen zwischen Prozessmodulen 2 bis 7 und Transfermodulen 21, 22 im Hinblick auf die geforderte Längsverfahrbarkeit der Transfermodule 21, 22 notwendig ist. Grundsätzlich liegt es aber auch im Rahmen der Erfindung, dass z. B. bei zur Führungsbahn 15, 16 in Querrichtung lagefester Abstützung der Transfermodule 21, 22 und dem jeweils anzudockenden Prozessodul 2 bis 7 ein dichtender Anschluss durch teleskopisches Ausfahren eines Zwischengliedes erreicht wird. Auch sind entsprechende Mischformen der abdichtenden Verbindungen im Rahmen der Erfindung möglich.

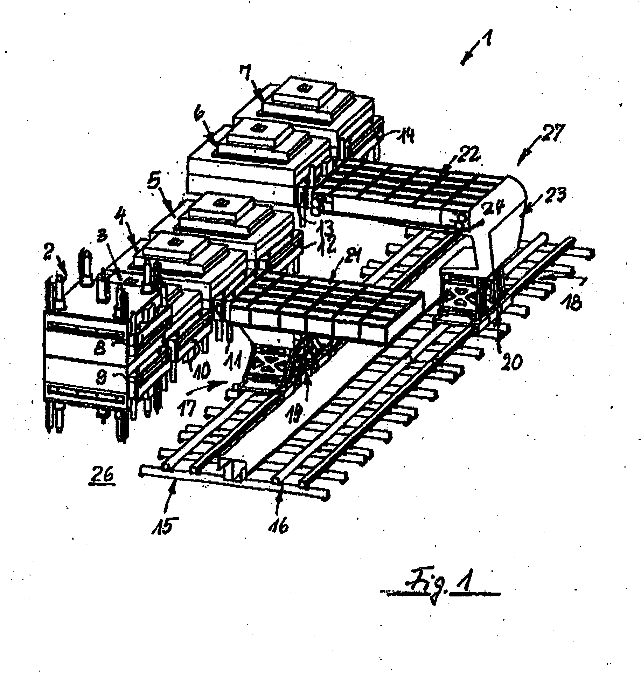

Der Aufbau einer Bearbeitungsanlage 1 in der in Fig. 1 dargestellten Form der Transfervorrichtung 27 ist insbesondere zweckmäßig, wenn die Prozessmodule 2 bis 7 im Hinblick auf die Umsetzung der Substrate in Berücksichtigung der Umsetzhäufigkeit und der Bearbeitungszeiten gegliedert angeordnet sind, und zwar sowohl bezüglich der Höhenlage ihrer Übergabeöffnungen 8 bis 14 wie auch ihres Abstandes zum als Übergabemodul ausgebildeten Prozessmodul 2, um weitmöglichst ohne Höhenversatz der Transfermodule 21, 22 in den Arbeitsläufen auszukommen, auch wenn ein solcher Höhenversatz im Rahmen der Erfindung möglich ist. Um wechselseitig aneinander vorbeifahren zu können, sind die Transfermodule 21, 22 entsprechend dem unterschiedlichen Abstand ihrer Führungsbahnen 15, 16 zu den Prozessmodulen 2 bis 7 in unterschiedlichem Abstand zu den Prozessmodulen 2 bis 7 über ihre jeweiligen Transferschlitten 19, 20 abgestützt, wobei das endseitig abgestützte Transfermodul 22 zum Transferschlitten 20 zusätzlich über einen Zwischenträger 23 in der Höhe versetzt angeordnet ist und auf einem Tragarm 24 des Zwischenträgers 23 derart abgestützt ist, dass zwischen dem Transferschlitten 20 und dem Transfermodul 22 ein Durchfahrweg für das Transfermodul 21 verbleibt.

Im Hinblick darauf, dass großflächige Reinräume zur Aufnahme von Bearbeitungsanlagen für Substrate insbesondere bei großflächigen Substraten schon unter wirtschaftlichen Gesichtspunkten sehr kritisch sind und dass auch die partielle Einhausung solcher Bearbeitungsanlagen mit sehr hohen Aufwendungen verbunden ist, insbesondere wenn höhere Reinraumklassen gefordert sind, wird bei einer Bearbeitungsanlage gemäß Fig. 1 davon ausgegangen, dass ein atmosphärisches Umfeld 26 gegeben ist und dass in jedem der Prozessmodule 2 bis 7 eigenständig der jeweilige Reinraumgrad aufgebaut und aufrecht erhalten wird, was in Anbetracht des Durchlaufs der Substrate über mehrere Prozessmodule 2 bis 7 im Rahmen der Erfindung mit wirtschaftlich beherrschbaren Mitteln und energiesparend dadurch erreicht wird, dass die Umsetzung der Substrate über Transfermodule 21, 22 erfolgt, in denen der jeweils in dem angedockten Prozessmodul 2 bis 7 gegebene Reinraumgrad aufrecht erhalten wird, oder auch in Anpassung an das nächstfolgend anzudockende Prozessmodul 2 bis 7 bereits verändert wird, wobei derartige Veränderungen bzw. Anpassungen gegebenenfalls schon bei der Übergabe auf das jeweilige Transfermodul 21, 22 erfolgen können.

Die Transfermodule 21, 22 sollten ungeachtet ihrer durch die jeweils geforderten Reinraumbedingungen bedingten, teilweise massiven Ausführung und durch die Größe der umzusetzenden Substrate bedingten Abmessungen - Substratgrößen von bis zu mehreren Quadratmetern bei Flachbildschirmen - eine möglichst geringe Masse aufweisen, um Transfervorgänge möglichst schnell durchführen zu können. Im Hinblick darauf ist bei der Ausgestaltung gemäß Fig. 2 dem dort gezeigten Prozessmodul 4 anschließend an seine Übergabeöffnung 11 eine Kupplungsvorrichtung 31 mit einem Gehäuse 32 lagefest zugeordnet, und es sind am Gehäuse 32, wie schematisch gezeigt, Flansche 33 vorgesehen, über die das jeweils anzudockende Transfermodul, in Fig. 2 das Transfermodul 21, mittels hier angedeuteter Spannvorrichtung 34, gegen das jeweilige Prozessmodul 4 bzw. gegen den Flansch 33 des Gehäuses 32 gezogen werden kann. Korrespondierend zum Flansch 33 des Gehäuses 32 ist bevorzugt auch seitens des Transfermodules 21 ein Flansch 35 vorgesehen. Als Spannvorrichtungen 34 können übliche Spannzangen vorgesehen sein, die über den Umfang des Übergabekanales 31 verteilt angeordnet sind. In Fig. 2 ist das Transfermodul 21 einerseits in seiner Freiganglage, also um das Freigangsmaß 30 beabstandet zur Kupplungsvorrichtung 31 und zum anderen gegen die Kupplungsvorrichtung 31 in Andocklage angelegt gezeigt.

Um einerseits mit einem möglichst kleinen Innenraumvolumen für die Kupplungsvorrichtung 31 auszukommen, die entsprechend der flächigen Ausbildung der Substrate einen flachen Rechteckquerschnitt mit einer Breite bis in die Größenordnung von 1,5 m aufweisen kann, und um das Eindringen atmosphärischer Verunreinigungen aus der Atmosphäre 26 in das Reinraumklima des Transfermodules 21 bzw. des Prozessmodules 4 weitmöglichst zu verhindern, ist das Transfermodul 21 überdeckend zu seiner Übergabeöffnung 25 mit einem Ventil 36 in Form einer Ventilplatte 37 versehen, die in ihrer Abdecklage bevorzugt flächenbündig zur Andockfläche 38 des Transfermodules 21 liegt. Der Übergabeöffnung 25 entspricht seitens der Kupplungsvorrichtung 31 in deren Gehäuse 32 eine Durchgangsöffnung 39, die in Fig. 2 von einem Absperrglied 40 überdeckt ist, das in der Andocklage des Transfermodules 21 flächig überdeckend zur Ventilplatte 27 liegt. Das Absperrglied 40 ist durch eine Sperrklappe 41 gebildet, die schwenkbar zum Gehäuse 32 der Kupplungsvorrichtung 31 nahe benachbart zur Andockebene 42 liegt, die in der Andocklage des Transfermodules 21 durch die Flansche 30 und 35 bestimmt ist. Die Schwenkachse der Sperrklappe 41 ist durch.die Welle 46 eines Stellantriebes bestimmt, der hier nicht dargestellt ist und über den die Sperrklappe 41 zwischen ihrer zur Durchgangsöffnung 39 überdeckenden Schließlage und einer Öffnungslage verstellbar ist, in der die Sperrklappe 41 aus dem durch die Übergabeöffnungen 11 und 25 bestimmten Durchgangsweg der Substrate verschwenkt ist, wobei eine entsprechende Durchgangsebene durch die Strichpunktlinie 44 schematisch angedeutet ist.

Für die Ventilplatte 37 ist in Fig. 2 die Schließlage angedeutet, in der die Ventilplatte 37 beispielsweise magnetisch haftend abdichtend zum Transfermodul 21 festgelegt ist, wobei davon ausgegangen ist, dass im Transfermodul 21 ein geringerer Druck als in der umgebenden Atmosphäre 26 herrscht. Im Rahmen der Erfindung liegen auch andere Möglichkeiten der Festlegung der Ventilplatte 37.

Zum Öffnen der Ventilplatte 37 wird diese im gezeigten Ausführungsbeispiel durch Unterdruck an die Sperrklappe 41 angelegt, also unter Nutzung eines Saugglockeneffektes, so dass bei der Verschwenkung der Sperrklappe 41 in dessen Öffnungslage auch die Ventilplatte 37 mitgenommen und damit der Durchgang vom Transfermodul 21 auf die Kupplungsvorrichtung 31 freigegeben wird. Bevorzugt ist, wie in Fig. 2 ersichtlich, die Unterdruckverbindung zur der Sperrklappe 41 zugeordneten Ansaugfläche 45 über die die Schwenkachse 43 bestimmende Welle 46 geführt. Aufgrund der unter Nutzung des Saugglockeneffektes herzustellenden Verbindung zwischen der Ventilplatte 37 und der Sperrklappe 41 wird im Vorfeld zum Öffnen des Übergangsweges der beim Andockvorgang im Bereich der Andockebene verbleibende Restraum evakuiert, so dass in Verbindung mit der Übergabe der Substrate zwischen dem Transfermodul 21 und dem jeweils angedockten Prozessmodul, hier dem Prozessmodul 4, keine Verunreinigung des Reinraumklimas stattfindet.

Der Übergabeöffnung 11 des Prozessmodules 4 ist seitens des angeschlossenen Gehäuses 32 der Kupplungsvorrichtung 31 eine Durchgangsöffnung 47 zugeordnet, und dieser wiederum als Ventil 48 eine Ventilplatte 49, die über eine Stellvorrichtung 50 in eine Öffnungslage verstellbar ist. In ihrer Öffnungslage ist die Ventilplatte 49 in eine Seitenkammer 51 des Gehäuses 32 der Kupplungsvorrichtung 31 verfahren, die ihrerseits bevorzugt von dem Bereich des Gehäuses 32 ausgeht, in den das Absperrglied 40 in seiner Öffnungslage verschwenkt ist.

Entsprechend dieser Anordnung ergibt sich bei der erfindungsgemäßen Gestaltung zunächst eine Freigabe der Übergabeöffnung 11 und der Durchgangsöffnung 47 zwischen Prozessmodul 4 und Kupplungsvorrichtung 31, bevor nach Abschluss des Andockvorganges für das Transfermodul 21 zur Kupplungsvorrichtung 31 die zugehörige Übergabeöffnung 25 und die Durchgangsöffnung 39 geöffnet werden.

Die in Fig. 2 dargestellte Lösung für das Ventil 36 in Form einer Ventilplatte 37 und das Ventil 48 in Form einer Ventilplatte 49 sowie für das Absperrglied 40 in Form einer Sperrklappe 41 stellt eine bevorzugte Lösung dar, die insbesondere zu einem geringen Volumen der Kupplungsvorrichtung 31 führt, im Rahmen der Erfindung liegen aber auch anderweitige Ausgestaltungen. Vereinfacht wird der Aufbau bei der erfindungsgemäßen Lösung auch dadurch, dass die gegebenen Druckverhältnisse sowohl hinsichtlich des Prozessmodules 4 wie auch des Transfermodules 21, jeweils ist Unterdruck gegenüber der umschließenden Atmosphäre 26 vorausgesetzt, dazu genutzt werden können, die Ventile in ihrer Schließlage dichtend festzulegen.

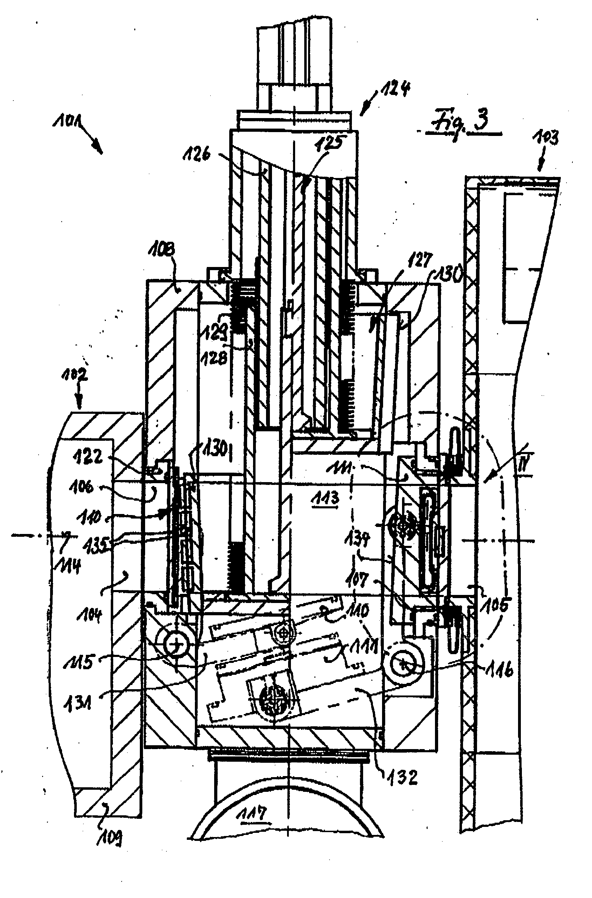

Ausgehend von den Grundgegebenheiten einer Bearbeitungsanlage 1 gemäß Fig. 1 und der bei einer solchen Bearbeitungsanlage 1 erforderlichen Kupplungsverbindung zwischen gegeneinander beweglichen, aneinander anzudockenden Modulen mit Abgrenzung gegen die umschließende Atmosphäre wird nachfolgend anhand der Fig. 3 bis 5 eine Kupplungsvorrichtung 101 näher erläutert, die im Übergang zwischen einem feststehenden Prozessmodul 102 und einem an dieses anzudockenden Transfermodul 103 liegt und über die die atmosphärisch in sich geschlossenen Innenräume dieser Module 102, 103, in denen bevorzugt Reinraumbedingungen herrschen, gegeneinander geöffnet und auch wieder geschlossen werden können, und zwar unter Vermeidung von Verunreinigungen auch in der An- und Abkupplungsphase. Die Erläuterung erfolgt in Berücksichtigung der Darlegungen zu Fig. 2, um Wiederholungen zu vermeiden.

In die Module 102 und 103, die als Prozess- und Transfermodule bezeichnet sind, die aber auch andere Funktionen haben können, weisen jeweils eine Übergabeöffnung 104 bzw. 105 auf, der seitens der Kupplungsvorrichtung 101 eine in Lage und Größe im Wesentlichen entsprechende Durchgangsöffnung 106 bzw. 107 zugeordnet ist, die im Gehäuse 108 der Kupplungsvorrichtung 101 angeordnet ist und die durch eine schwenkbare Sperrklappe 110 bzw. 111 zu verschließen ist. Aufgrund der lagefesten, dichtenden Verbindung zwischen dem Gehäuse 108 der Kupplungsvorrichtung 101 zum Mantel 109 des Prozessmodules 102 ist zum Verschließen des Durchgangs vom Prozessmodul 102 auf die Kupplungsvorrichtung 1, und damit zum Schließen des Prozessmodules 102 lediglich die Sperrklappe 110 erforderlich.

Gegenüberliegend muss, bei nicht angedocktem Transfermodul 103, einerseits die Übergabeöffnung 105 des Transfermodules 103 und andererseits die Durchgangsöffnung 107 im Kupplungsgehäuse 108 geschlossen werden, um in den jeweiligen Innenräumen die gewünschte Atmosphäre, insbesondere Reinraumatmosphäre aufrechtzuerhalten. Hierzu ist der Durchgangsöffnung 107 eine Sperrklappe 111 als Absperrglied zugeordnet und der Übergabeöffnung 105 als Ventil eine Ventilplatte 112, die zum Öffnen der Übergabeöffnung 105 zusammen mit der Sperrklappe 111 in den Innenraum 113 der Kupplungsvorrichtung 101 eingeschwenkt wird.

Sowohl die Sperrklappe 110 wie auch die Sperrklappe 111 sind um eine unterhalb der jeweiligen Durchgangsöffnung 106 bzw. 107 liegende, zur liegenden Durchgangsebene 114 parallele Schwenkachse 115, 116 nach unten in den Innenraum 113 einschwenkbar, wobei die Sperrklappe 111 entsprechend dem funktionalen Ablauf beim Öffnen und Schließen der über die Kupplungsvorrichtung 111 herzustellenden Durchgangsverbindung zwischen den Modulen 102, 103 unterhalb der Sperrklappe 110 zu liegen kommt, die als zweite geöffnet aber als erste geschlossen wird. Der Innenraum 113 ist, wie bei 117 angedeutet, an eine Unterdruckquelle angeschlossen und wird dementsprechend konditioniert, bevor die als zweite zu öffnende Sperrklappe 110 im Zugang zum Prozessmodul 102 geöffnet wird.

Entsprechendes ist auch bei der Übergabe von Substraten auf das Transfermodul 103 möglich, wobei die Konditionierung des Innenraumes 113 und gegebenenfalls auch des angeschlossenen Prozessmodules 102 über die Unterdruckquelle 117 erfolgen kann, bevor die Sperrklappe 111 geöffnet wird. Damit wird es möglich, beispielsweise Partikelablagerungen auf der Sperrklappe 110 oder in sonstigen Bereichen des Innenraumes 113, sowie auch etwaige Ausgasungen abzuführen, bevor eine Übergabe des jeweiligen Substrates auf das Transfermodul 103 erfolgt.

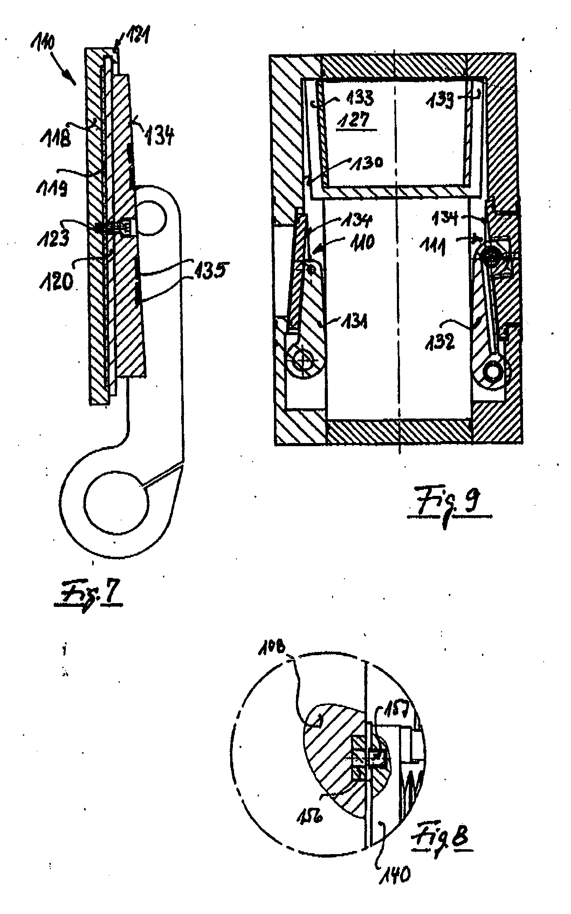

Im Hinblick auf die in Abhängigkeit vom jeweiligen der in einem Prozessmodul 102 durchgeführten Prozesse, die teilweise unter hohen Temperaturen ablaufen, weist die Sperrklappe 110 beispielsweise einen Aufbau gemäß Fig. 7 auf, mit einer Deckplatte 118 und einer diese untergreifenden Isolierung 119, wobei die Deckplatte 118 zu einer Tragplatte 120 bevorzugt über einen lediglich längs einer Seite übergreifenden Rand 121 festgelegt ist, so dass Verwerfungen der Deckplatte 118 aufgrund von Wärmedehnungen oder dergleichen vermieden werden können und die Deckplatte 118 ungeachtet stark wechselnder Bedingungen in dichtender Anlage zu einer Randeinfassung 122 der Durchgangsöffnung 106 gehalten werden kann. Lediglich zu Sicherungszwecken ist auch eine angedeutete, bevorzugt zentrale Verschraubung der Deckplatte 118 zur Tragplatte 120 vorgesehen, wobei die Verschraubung 123 ebenfalls entsprechend spielbehaftet ausgeführt werden kann.

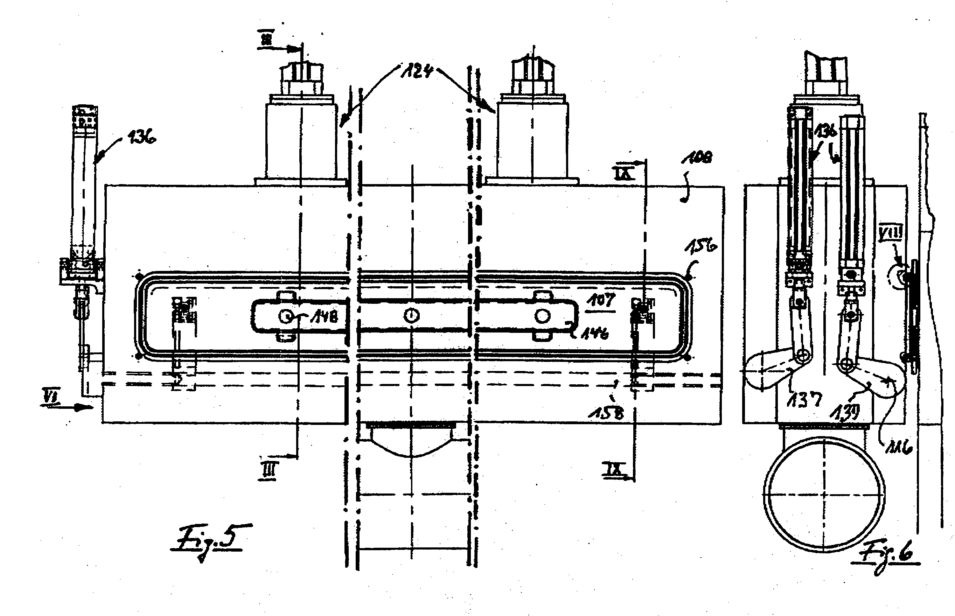

Die Sperrklappen 110 und 111 werden, wie in Fig. 3 schematisiert dargestellt, in Richtung auf ihre Schließlage über eine zentrale Abstützvorrichtung 124 gegeneinander abgestützt. Die insoweit dargestellte Abstützvorrichtung 124 , siehe hierzu auch Fig. 9, stellt ein Ausführungsbeispiel dar, das besonders vorteilhaft ist, da es eine Lösung verkörpert, die trotz der wechselseitigen Beweglichkeit der Teile und der zu übertragenden Kräfte weitestgehend berührungsfrei arbeitet und damit Verunreinigungen durch Abrieb weitestgehend vermeidet, ungeachtet dessen, dass Durchgangsöffnungen 106 und 107 sowie die Übergabeöffnungen 104 und 105 als, wie aus Fig. 5 ersichtlich, langgestreckte Rechtecke mit einer Länge bis in die Größenordnung von 1 und 2 m ausgebildet sind. Bezogen auf das Ausführungsbeispiel umfasst die Abstützvorrichtung 124 zwei Stellzylinder 125, die in Längsrichtung der Durchgangsöffnung 106 bzw. 107 beabstandet senkrecht zur Durchgangsebene 114 stehen. Die Stellzylinder 125 verlaufen jeweils innerhalb einer umschließenden Führungshülse 126 und beaufschlagen einen Sperrkörper 127, der, bezogen auf den jeweiligen Stellzylinder 125, zur Führungshülse 126 über ein Führungsrohr 128 rollengeführt abgestützt ist. Das Führungsrohr 128 läuft auf den Boden des trogförmigen Sperrkörpers 127 aus und ist von einem Faltenbalg 129 ummantelt, so dass die Führungsteile der Abstützvorrichtung 124 gegen den Innenraum 113 atmosphärisch abgegrenzt sind.

Der trogförmige Sperrkörper 127 erstreckt sich im Wesentlichen über die Länge der Sperrklappen 110, 111 und weist längsseitlich in Spannrichtung aufeinander zulaufende Längsseitenwände 130 auf, die im Bereich Schwenkarme 131, 132 der Sperrklappen 110, 111 entsprechend mit Aussparungen 133 versehen sind. Abgesehen von diesen Aussparungen 133 verlaufen die Längsseitenwände 130 parallel zu den entsprechend geneigten Rückseiten 134 der über den Sperrkörper 127 in ihrer Sperrlage zu verspannenden Sperrklappen 110, 111, derart, dass in der Sperrlage bei berührungsfreier Lage des Sperrkörpers 127 zu den Sperrklappen 110, 111 lediglich ein geringes Spaltspiel vorhanden ist. Die Verspannung der Sperrklappen 110, 111 über den Sperrkörper 127 erfolgt berührungsfrei über Magneten 135, die einerseits rückseitig an den Sperrklappen 110, 111 und andererseits an den Längsseitenwänden 130 des Sperrkörpers 127 vorgesehen sind und die gleichsinnig gepolt sind, so dass sich entsprechende Abdrängkräfte ergeben. Als Magneten sind leistungsstarke Permanentmagneten vorgesehen, die mit ihren gegeneinander gerichteten Polflächen parallel zur Neigungsebene der Längsseitenwände 130 bzw. der Rückseiten 134 der Sperrklappen 110, 111 liegen. Die Magnete sind bevorzugt teppichartig längs der Längsseitenwände 130 bzw. der Rückseiten 134 der Sperrklappen 110, 111 vorgesehen, so dass sich durch die Summe der Magneten sehr hohe Abdrängkräfte ergeben, wie sie im Hinblick darauf erforderlich sind, dass die Sperrklappe 111 bei nicht angedocktem Transfermodul 103 im Regelfall mit atmosphärischem Druck beaufschlagt ist.

Die Betätigung der Sperrklappen 110, 111 ist in Fig. 5 und 6 schematisiert dargestellt und erfolgt über zum Kupplungsgehäuse 108 angesetzte Stellzylinder 136, die den Sperrklappen 110, 111 koaxial zu ihren Drehachsen zugeordnete Schwenkhebel 137 beaufschlagen.

Beim Andockvorgang des Transfermoduls 103 an das Gehäuse 108 der Kupplungsvorrichtung 101 sind in Bezug auf mögliche Verunreinigungen aus der Atmosphäre sowohl möglichst kleine Schadräume anzustreben, und es ferner auch zu gewährleisten, dass das Transfermodul 103 ungeachtet der gegebenen großflächigen Dichtflächen, die durch die Größe der Übergabeöffnung 105 und der Durchgangsöffnung 107 bedingt sind, keine schädlichen Spaltbildungen ergeben.

Um Führungsfehler auszugleichen und eine weitgehend stoßfreie, weiche Anlage des Transfermodules 103 zur Kupplungsvorrichtung 101 zu erreichen, ist das Transfermodul 103 umschließend zu seiner Übergabeöffnung 105 mit einer Brille 140 versehen. Diese Brille 140 ist in Richtung auf die Kupplungsvorrichtung 101, also in Vorschubrichtung 142 des Transfermodules 103 gegen die Kupplungsvorrichtung 101 zum Rahmen 141 seitlich versetzt vorgelagert und umschließt die Ventilplatte 112 in ihrer das Transfermodul 103 verschließenden Abdecklage, in der die Ventilplatte 112 stirnseitig dichtend auf den Rahmen 141 aufliegt. Die Brille 140 ist in Vorschubrichtung 142 federnd gegen den Rahmen 141 abgestützt sowie auch über einen Faltenbalg 143 dichtend mit dem Rahmen 141 verbunden, wobei über den Faltenbalg 143 auch die in Vorschubrichtung 142 federnde Abstützung erreicht werden kann. Geführt ist die Brille 140 darüber hinaus gegenüber dem Rahmen über gegen den Rahmen 141 und die Brille 140 verspannte Schenkelfedern 144, die in Umfangsrichtung versetzt zueinander längs des Umfangs der Brille 140 vorgesehen sind.

Der Ventilplatte 112 gegenüberliegend ist seitens der Sperrklappe 111 eine Kammer 145 vorgesehen, in der axial in Vorschubrichtung 142 federnd abgestützt eine Tragplatte 146 vorgesehen ist. Korrespondierend sind die Tragplatte 146 und die Ventilplatte 112 mit Haftmagneten 147, 148 versehen ist, so dass bei Anlage der Tragplatte 146 an der Ventilplatte 112 diese magnetisch haftend verbunden sind. Die federnde Abstützung der Tragplatte 146 zur Kammer 145 erfolgt bevorzugt über Bügelfedern 149, die jeweils mit ihrem durchlaufenden Schenkel 150 gegen den Boden der Kammer 145 festgelegt sind und mit ihren frei auslaufenden, gegeneinander eingebogenen Schenkeln 151 zur Tragplatte 156 festgelegt sind, bei Begrenzung des Schwenkweges dieser Schenkel 151 in Richtung auf die Ventilplatte 112.

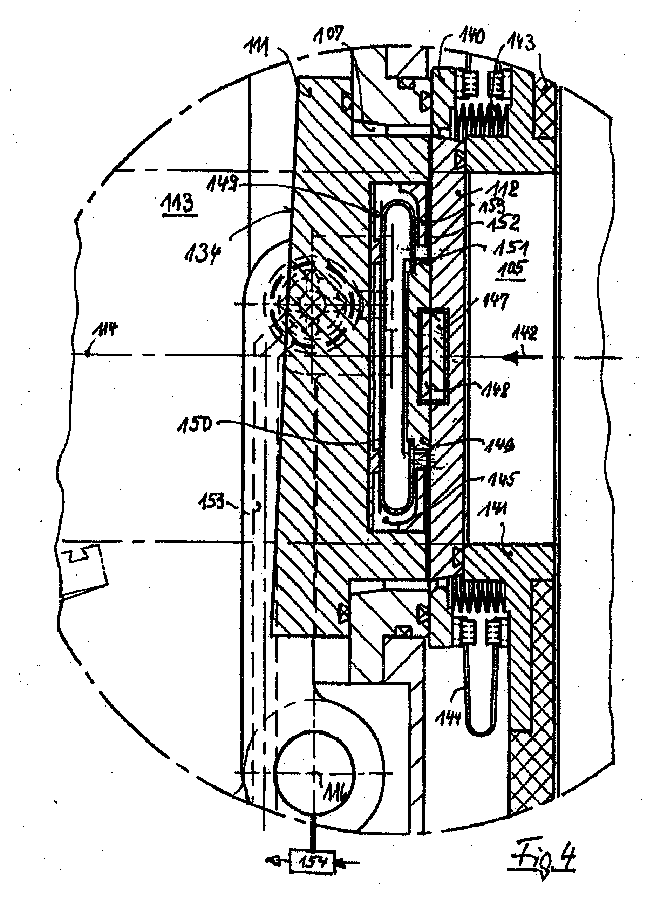

Bezogen auf die in Fig. 4 dargestellte Montagelage liegt die Sperrklappe 111 bei innenseitiger dichtender Abstützung gegen das Gehäuse 108 am Gehäuse an und ist dadurch in ihrer Eintauchtiefe in die Durchgangsöffnung 107 begrenzt. Die Ventilplatte 112 liegt ihrerseits dichtend am Rahmen 141 an und die Brille 140 ist durch die federnde Abstützung zum Rahmen 141 gegen das Gehäuse 108 der Kupplungsvorrichtung abgestützt. Ferner ist die Tragplatte 146 gegen die Ventilplatte 112 über die Bügelfeder 149 belastet und somit gegen den Rahmen 141 angelegt.

Voraufgehend zu dieser Montagelage ist die Tragplatte 146 in Richtung auf die Ventilplatte 112 ausgestellt, wegbegrenzt durch eine Anschlagstellung der Schenkel 151 zur Sperrklappe 111, die durch zur Kammer 145 vorgesehene Einsätze 159 gebildet ist. Somit ist beim Anfahren der Montagelage zunächst eine zur Atmosphäre offene Verbindung gegeben, und es kann der zwischen der Kupplungsvorrichtung 101 und dem Transfermodul 103 gegebene Spaltbereich zunächst durch Einblasen von Reinluft auf die Kammer 145 gegen die Atmosphäre freigeblasen werden. Mit der Anlage der Brille 140 wird das noch gegebene Spaltvolumen gegen die Atmosphäre geschlossen und kann nun durch Absaugen über den Spalt 152 gereinigt werden, bevor die Sperrklappe 111 geöffnet wird. Die Leitungsverbindung zur Kammer 145 ist mit 153 bezeichnet und in einem Schwenkarm 132 für die Sperrklappe 111 bevorzugt vorgesehen, wobei die Luftführung bevorzugt über die zur Achse 116 konzentrische hohle Antriebswelle 158 der Sperrklappe 111 läuft. Zur Umschaltung von Blasen auf Saugen ist ein Schaltventil 154 vorgesehen und angedeutet, das entsprechende saug- und druckseitige Anschlüsse aufweist.

Der Spalt 152 ist durch entsprechende Dimensionierung der Sperrklappe 111 und deren dadurch festgelegte Eintauchtiefe sowie die Dicke der Ventilplatte 112 vorgegeben, wobei die Ventilplatte 112 über die abstützende Bügelfeder 159 in Richtung auf ihre abdichtende Sperrlage belastet ist.

Die Figuren veranschaulichen des Weiteren, dass die jeweilige Sperrklappe 110 bzw. 112 zu ihrem Schwenkarm 131 bzw. 132 bevorzugt schwenkbeweglich abgestützt ist.

Aufgrund der Abstützung der Tragplatte 146 über die Bügelfeder 149 ist die Ventilplatte 112 auch über die Bügelfeder 149 in der gezeigten Schließlage in Schließrichtung beaufschlagt. Die entgegengesetzte Mitnahmekraft beim Öffnen der Sperrklappe 111 wird über die Bügelfeder 149 ebenfalls auf die Tragplatte 146 übertragen, und es kann dadurch die Ventilplatte 112 über die Sperrklappe 111 mitgenommen werden, da der Ausfederweg für die Schenkel 151 der Bügelfeder 149 über zur Ventilplatte 111 festliegende Anschläge begrenzt ist.

Fig. 5 und 8 veranschaulichen, dass randseitig zur Durchgangsöffnung 107 benachbart und, bezogen auf die Andocklage des Transfermoduls 103, zur Kupplungsvorrichtung 101 in Überdeckung zur Brille 140 am Gehäuse 108 der Kupplungsvorrichtung 101 und jeweils gegenüberliegend an der Brille 110 gleichgepolte Magnete 156, 157 vorgesehen sind. Aufgrund der federnden Abstützung der Brille 140 zum Rahmen 141 ist über diese Magnetanordnung eine Ausrichtung der Brille 141 auf eine Parallellage zu ihrer Anlagefläche am Gehäuse 108 der Kupplungsvorrichtung 101 möglich, so dass auch bei leicht verschränkten Lagen des Transfermodules 103 zum Prozessmodul 102 noch die gewünschte dichtende Verbindung erreicht werden kann, wobei die auszugleichenden Toleranzen gering sind. Eine entsprechende Magnetanordnung ist in Fig. 8 veranschaulicht, wobei die seitens der Kupplungsvorrichtung 101 vorgesehenen Magnete mit 156 und die seitens der Brille 140 vorgesehenen Magnete mit 157 bezeichnet sind und die Magnete 156 als Ringmagnete ausgebildet sind, zu deren zentraler Ausnehmung die Magnete 157 in Überdeckung liegen, wobei die Anordnung derart ist, dass sich auch in der Montagelage noch ein Luftspalt zwischen den Magneten 156, 157 ergibt.

Durch die geschilderte erfindungsgemäße Ausgestaltung einer Kupplungsvorrichtung 101 ist insbesondere auch der bezogen auf Verunreinigungen kritische Andockvorgang zwischen Transfermodul 103 und Kupplungsvorrichtung 111 trotz der atmosphärischen Umgebung gut zu beherrschen. Von Vorteil ist hierzu insbesondere beim Zulaufen des Transfermodules 103 auf die Kupplungsrichtung 101 über die Leitungsverbindung 153 zunächst Reinluft auszublasen, so dass die Kammer 145 sowie auch die daran angrenzenden und davon ausgehenden Spaltverbindungen freigeblasen werden. Nach abdichtender Anlage der Brille 140 gegen das Gehäuse 108 wird in Gegenrichtung abgesaugt, so dass sich ein entsprechender Unterdruck aufbaut, über den zugleich auch eine unterdruckbedingte Anlage der Ventilplatte 112 gegen die Sperrklappe 111 erreicht werden kann, wenn sich die Ventilplatte 112 in ihrer von der Sperrklappe 111 getragenen Öffnungslage gegen die Sperrklappe 111 randseitig abstützt.

Die erfindungsgemäße Kupplungsvorrichtung bildet zwar in ihrer Gesamtheit eine besonders vorteilhafte Lösung zum Einsatz in einer Bearbeitungsanlage modularen Aufbaus der beschriebenen Art, ist aber auch außerhalb solcher Bearbeitungsanlagen beispielsweise dann mit Vorteil einzusetzen, wenn Prozessmodule miteinander verkuppelt werden sollen, die aus Versorgungs-, Wartungs- oder Kontrollgründen kurzfristig getrennt und wieder aneinander angeschlossen werden sollen. Zudem erlaubt eine solche Kupplungsvorrichtung bei entsprechender Bemessung auch in günstiger Weise eine Konditionierung zwischen zueinander anschließenden Modulen.

Ferner liegt es im Rahmen der Erfindung, wesentliche Teile der Kupplungsvorrichtung auch separat einzusetzen, so beispielsweise Sperrklappen des geschilderten Aufbaus mit Isolierverhalten, oder Sperrklappen des geschilderten Aufbaus mit Tragfunktion für eine abzunehmende Ventilplatte oder solche Sperrklappen auch in Verbindung mit einer Brillenanordnung der beschriebenen Art, wobei die Brillenanordnung auch als solche einen eigenständigen erfindungswesentlichen Gegenstand darstellt, der bei trennbaren Systemen eine schnelle und schonende Ankupplung ermöglicht, wobei in Verbindung mit dem Anlegen der Brille vorab über die gleichpolige Anordnung von Magneten eine Ausrichtung der Brille auf die jeweilige Anschlussfläche möglich ist, so dass Verkantungen vermieden werden.

## Patentansprüche

1. Bearbeitungsanlage (1) modularen Aufbaus für flächige Substrate unter atmosphärischen Sonderbedingungen, insbesondere für großflächige mikroelektronische Werkstücke wie Flachbildschirme unter Reinraumbedingungen,
∘ mit gekapselten Prozessmodulen (102),
∘ mit wenigstens einem gekapselten Transfermodul (103),
∘ mit einer im Übergang zwischen einem Prozessmodul (102) und einem angedockten Transfermodul (103) liegenden Kupplungsvorrichtung (101),
∘ mit an den Prozessmodulen (102) und dem Transfermodul (103) vorgesehenen Übergabeöffnungen (104, 105),
∘ mit an der Kupplungsvorrichtung (101) vorgesehenen, korrespondierend zu den Übergabeöffnungen (104, 105) vorgesehenen, einander gegenüberliegenden Durchgangsöffnungen (146, 107), und
∘ mit Sperrklappen (110, 111) für die Durchgangsöffnungen (106, 107), die in ihrer Öffnungslage in den Innenraum (113) der Kupplungsvorrichtung (101) eingeschwenkt und in ihrer Schließstellung über eine gemeinsame Abstützvorrichtung (124) beaufschlagt sind,
**dadurch gekennzeichnet,**
**dass** die Abstützvorrichtung (124) durch einen zwischen die Sperrklappen (110, 111) einfahrbaren Keilschieber gebildet ist, dessen Keilflächen zu entsprechend geneigten Gegenflächen der Sperrklappen (110, 111) korrespondieren und dass die Sperrklappen (110, 111) über den Keilschieber dadurch berührungsfrei beaufschlagt sind, dass die Keilflächen des Keilschiebers und die Gegenflächen der Sperrklappen (110, 111) mit gleichpolig aufeinander ausgerichteten Magneten (135) versehen sind.

2. Bearbeitungsanlage nach Anspruch 1,
**dadurch gekennzeichnet,**
**dass** die Magneten (135) durch Permanentmagneten gebildet sind, deren Polflächen parallel zu den jeweiligen Neigungsebenen der Keilflächen und der Gegenflächen liegen.

3. Bearbeitungsanlage nach Anspruch 2,
**dadurch gekennzeichnet,**
**dass** die Magneten (135) teppichartig zu den jeweiligen Keilflächen und Gegenflächen angeordnet sind.

4. Bearbeitungsanlage nach einem der vorhergehenden Ansprüche,
**dadurch gekennzeichnet,**
**dass** der Keilschieber im Wesentlichen über die Länge der Sperrklappen (110, 111) verlaufend und trogförmig ausgebildet ist.'

5. Bearbeitungsanlage nach Anspruch 4,
**dadurch gekennzeichnet,**
**dass** der Keilschieber in seinen in Spannrichtung aufeinander zulaufenden Keilflächen Aussparungen (133) aufweist, die im Bereich von Schwenkarmen (131, 132) der Sperrklappen (110, 111) liegen, über die die Sperrklappen (110, 111) nach unten in eine wechselseitige Überdeckungslage als Öffnungslage einzuschwenken sind.

6. Bearbeitungsanlage (1) modularen Aufbaus für flächige Substrate unter atmosphärischen Sonderbedingungen, insbesondere für großflächige mikroelektronische Werkstücke wie Flachbildschirme unter Reinraumbedingungen
∘ mit gekapselten Prozessmodulen (102),
∘ mit wenigstens einem gekapselten Transfermodul (103),
∘ mit einer im Übergang zwischen einem Prozessmodul (102) und einem angedockten Transfermodul (103) liegenden Kupplungsvorrichtung (101),
∘ mit an den Prozessmodulen (102) und an dem Transfermodul (103) vorgesehenen Übergabeöffnungen (104, 105), mit an der Kupplungsvorrichtung (101) vorgesehener, korrespondierend zu den Übergabeöffnungen (104, 105) vorgesehenen, einander gegenüberliegenden Durchgangsöffnungen (106, 107), und
∘ mit einem im Übergang von einem Modul auf die Kupplungsvorrichtung (101) umschließend zur Übergabeöffnung (105) vorgesehenen Faltenbalg (143),
**dadurch gekennzeichnet,**
**dass** der Faltenbalg (143) im Übergang vom Transfermodul (103) auf die Kupplungsvorrichtung (101) angeordnet und mit einer zur Durchgangsöffnung (107) umschließenden, federnd abgestützten Brille (140) versehen ist, die zum Transfermodul (103) schwimmend geführt ist, wobei die Brille (140) und die Kupplungsvorrichtung (101) an ihren einander zugeordneten Anlageflächen mit korrespondierend zueinander vorgesehenen und gleichpolig aufeinander ausgerichteten Magneten (156, 157) versehen sind, derart, dass die Brille (140) bei Annäherung an die Kupplungsvorrichtung (101) parallel zu deren Anlagefläche ausgerichtet wird.

7. Bearbeitungsanlage nach Anspruch 6,
**dadurch gekennzeichnet,**
**dass** die Brille (140) über Schenkelfedern (144) zum Transfermodul (103) schwimmend geführt ist.

8. Bearbeitungsanlage nach Anspruch 7,
**dadurch gekennzeichnet,**
**dass** der von der Brille (140) in Andocklage des Transfermoduls (103) zur Kupplungsvorrichtung (101) umschlossene Übergabebereich vor Anlegen der Brille durch Ausblasen von Reinluft auf die umschließende Atmosphäre gereinigt wird.

9. Bearbeitungsanlage nach Anspruch 7,
**dadurch gekennzeichnet,**
**dass** der von der Brille (140) in Andocklage des Transfermoduls (103) zur Kupplungsvorrichtung (101) umschlossene Bereich nach Anlegen der Brille (140) an die Kupplungsvorrichtung (101') durch Absaugen gereinigt wird.

10. Bearbeitungsanlage nach Anspruch 8 oder 9,
**dadurch gekennzeichnet,**
**dass** die Saug- bzw. Druckluftführung über die Sperrklappe (111) verläuft.

## Claims

1. Installation (1) of modular construction for the working of flat substrates under special atmospheric conditions, in particular for microelectronic workpieces of a large area, such as flat screens, under clean room conditions,
∘ with encapsulated process modules (102),
∘ with at least one encapsulated transfer module (103),
∘ with a coupling device (101), lying at the transition between a process module (102) and a docked-on transfer module (103),
∘ with transfer openings (104, 105), provided on the process modules (102) and the transfer module (103),
∘ with through-openings (106, 107), lying opposite one another, provided on the coupling device (101) and provided so as to correspond to the transfer openings (104, 105), and
∘ with dampers (110, 111) for the through-openings (106, 107), which in their open position have been swung into the interior space (113) of the coupling device (101) and in their closed position have been acted upon by a common supporting device (124),
**characterized**
**in that** the supporting device (124) is formed by wedge gate valves, which can be moved between the dampers (110, 111) and the wedge surfaces of which correspond to correspondingly inclined mating surfaces of the dampers (110, 111), and in that the dampers (110, 111) are acted upon in a contactless manner by the wedge gate valve by the wedge surfaces of the wedge gate valve and the mating surfaces of the dampers (110, 111) being provided with magnets (135) made to face one another with the same polarity.

2. Working installation according to Claim 1,
**characterized**
**in that** the magnets (135) are formed by permanent magnets, the pole surfaces of which lie parallel to the respective planes of inclination of the wedge surfaces and the mating surfaces.

3. Working installation according to Claim 2,
**characterized**
**in that** the magnets (135) are arranged in a carpet-like manner with respect to the respective wedge surfaces and mating surfaces.

4. Working installation according to one of the preceding claims,
**characterized**
**in that** the wedge gate valve is formed so as to extend substantially over the length of the dampers (110, 111) and take the form of a trough.

5. Working installation according to Claim 4,
**characterized**
**in that**, in its wedge surfaces running towards one another in the clamping direction, the wedge gate valve has clearances (133), which lie in the region of pivoting arms (131, 132) of the dampers (110, 111) and by means of which the dampers (110, 111) can be made to swing downwards into a mutually covering position as the open position.

6. Installation (1) of modular construction for the working of flat substrates under special atmospheric conditions, in particular for microelectronic workpieces of a large area, such as flat screens, under clean room conditions,
∘with encapsulated process modules (102),
∘ with at least one encapsulated transfer module (103),
∘ with a coupling device (101), lying at the transition between a process module (102) and a docked-on transfer module (103),
∘ with transfer openings (104, 105), provided on the process modules (102) and the transfer module (103), with through-openings (106, 107), lying opposite one another, provided on the coupling device (101) and provided so as to correspond to the transfer openings (104, 105), and
∘ with a bellows (143), provided at the transition from a module to the coupling device (101) in such a way as to enclose the transfer opening (105),
**characterized in that** the bellows (143) is arranged at the transition from the transfer module (103) to the coupling device (101) and is provided with a resiliently supported gland (140) which encloses the through-opening (107) and is guided in a floating manner with respect to the transfer module (103), the gland (140) and the coupling device (101) being provided on their mutually assigned abutting surfaces with magnets (156, 157), provided so as to correspond to one another and made to face one another with the same polarity, in such a way that, when approaching the coupling device (101), the gland (140) is aligned parallel to the abutting surface.

7. Working installation according to Claim 6,
**characterized**
**in that** the gland (140) is guided in a floating manner with respect to the transfer module (103) by means of leg springs (144).

8. Working installation according to Claim 7,
**characterized**
**in that** the transfer region enclosed by the gland (140) in the docking position of the transfer module (103) with respect to the coupling device (101) is cleaned before applying the gland by blowing out clean air onto the surrounding atmosphere.

9. Working installation according to Claim 7,
**characterized**
**in that** the region enclosed by the gland (140) in the docking position of the transfer module (103) with respect to the coupling device (101) is cleaned after applying the gland (140) to the coupling device (101) by suction extraction.

10. Working installation according to Claim 8 or 9,
**characterized**
**in that** the suction air or compressed air is made to pass via the damper (111).

## Revendications

1. Installation de traitement (1) de construction modulaire pour des substrats plats dans des conditions atmosphériques spéciales, en particulier pour des pièces micro-électroniques de grandes surfaces telles que des écrans plats dans des conditions de salles propres, comprenant :
- des modules de traitement encapsulés (102),
- au moins un module de transfert encapsulé (103),
- un dispositif d'accouplement (101) situé à la transition entre un module de traitement (102) et un module de transfert arrimé (103),
- des ouvertures de transfert (104, 105) prévues au niveau des modules de traitement (102) et du module de transfert (103),
- des ouvertures de passage (106, 107) prévues au niveau du dispositif d'accouplement (101) prévues de manière correspondant aux ouvertures de transfert (104, 105), opposées l'une à l'autre, et
- des volets de fermeture (110, 111) pour les ouvertures de passage (106, 107), qui sont pivotés vers l'intérieur dans leur position d'ouverture dans l'espace intérieur (113) du dispositif d'accouplement (101) et qui sont sollicités par le biais d'un dispositif de support commun (124) dans leur position de fermeture,
**caractérisée en ce que**
le dispositif de support (124) est formé par un coulisseau à came pouvant être enfoncé entre les volets de fermeture (110, 111), dont les surfaces de came correspondent à des surfaces conjuguées inclinées de manière correspondante des volets de fermeture (110, 111), et **en ce que** les volets de fermeture (110, 111) sont sollicités sans contact par le biais du coulisseau à came par le fait que les surfaces de came du coulisseau à came et les surfaces conjuguées des volets de fermeture (110, 111) sont pourvues d'aimants (135) de même polarité orientés les uns vers les autres.

2. Installation de traitement selon la revendication 1,
**caractérisée en ce que**
les aimants (135) sont formés par des aimants permanents dont les surfaces polaires sont parallèles aux plans d'inclinaison respectifs des surfaces de came et des surfaces conjuguées.

3. Installation de traitement selon la revendication 2,
**caractérisée en ce que**
les aimants (135) sont disposés à la manière de tapis par rapport aux surfaces de came et aux surfaces conjuguées respectives.

4. Installation de traitement selon l'une quelconque des revendications précédentes,
**caractérisée en ce que**
le coulisseau à came est réalisé de manière à s'étendre essentiellement sur la longueur des volets de fermeture (110, 111) et en forme d'auge.

5. Installation de traitement selon la revendication 4,
**caractérisée en ce que**
le coulisseau à came présente des évidements (133) dans ses surfaces de came tournées l'une vers l'autre dans la direction de serrage, lesquels sont situés dans la région de bras pivotants (131, 132) des volets de fermeture (110, 111), par le biais desquels les volets de fermeture (110, 111) doivent pivoter vers le bas dans une position de recouvrement mutuelle en tant que position d'ouverture.

6. Installation de traitement (1) de construction modulaire pour des substrats plats dans des conditions atmosphériques spéciales, en particulier pour des pièces micro-électroniques de grandes surfaces telles que des écrans plats dans des conditions de salles propres, comprenant :
- des modules de traitement encapsulés (102),
- au moins un module de transfert encapsulé (103),
- un dispositif d'accouplement (101) situé à la transition entre un module de traitement (102) et un module de transfert arrimé (103), avec des ouvertures de transfert (104, 105) prévues au niveau des modules de traitement (102) et du module de transfert (103),
- des ouvertures de passage (106, 107) prévues au niveau du dispositif d'accouplement (101) prévues de manière correspondant aux ouvertures de transfert (104, 105), opposées l'une à l'autre, et
- un soufflet (143) prévu à la transition d'un module au dispositif d'accouplement (101) circonférentiellement par rapport à l'ouverture de transfert (105),
**caractérisée en ce que**
le soufflet (143) est disposé à la transition du module de transfert (103) au dispositif d'accouplement (101) et est pourvu de lunettes (140) supportées élastiquement, circonférentielles par rapport à l'ouverture de passage (107), qui sont guidées de manière flottante par rapport au module de transfert (103), les lunettes (140) et le dispositif d'accouplement (101) au niveau de leurs surfaces d'appui associées l'une à l'autre étant pourvus d'aimants (156, 157) de même polarité prévus de manière à se correspondre mutuellement et orientés l'un vers l'autre, de telle sorte que les lunettes (140), lorsqu'elles se rapprochent du dispositif d'accouplement (101), soient orientées parallèlement à leur surface d'appui.

7. Installation de traitement selon la revendication 6,
**caractérisée en ce que**
les lunettes (140) sont guidées de manière flottante par le biais de ressorts à branches (144) par rapport au module de transfert (103).

8. Installation de traitement selon la revendication 7,
**caractérisée en ce que**
la région de transfert entourée par les lunettes (140) dans la position d'arrimage du module de transfert (103) par rapport au dispositif d'accouplement (101) est nettoyée avant l'application des lunettes par soufflage d'air propre sur l'atmosphère environnante.

9. Installation de traitement selon la revendication 7,
**caractérisée en ce que**
la région entourée par les lunettes (140) dans la position d'arrimage du module de transfert (103) par rapport au dispositif d'accouplement (101) est nettoyée par aspiration après l'application des lunettes (140) contre le dispositif d'accouplement (101).

10. Installation de traitement selon la revendication 8 ou 9,
**caractérisée en ce que**
le guidage d'air d'aspiration ou d'air comprimé s'effectue via le volet de fermeture (111).
